# EUROPEAN PATENT APPLICATION

(11) **EP 4 513 563 A1**
(43) Date of publication of application: **26.02.2025**
(21) Application number: 22963174.2
(22) Date of filing: 28.10.2022
(51) Int. Cl.: H01L 27/12, G02F 1/1345

(54) **DISPLAY MODULE AND PREPARATION METHOD THEREFOR, AND DISPLAY APPARATUS**

(71) Applicant: Boe Technology Group Co., Ltd., Beijing 100015 (CN); Nanjing Boe Display Technology Co., Ltd., Nanjing, Jiangsu 210033 (CN)
(72) Inventor: FU, Baoze, Beijing 100176 (CN)
(74) Representative: Haseltine Lake Kempner LLP
(86) International application number: PCT/CN2022/128348
(87) International publication number: WO 2024/087192

(57) **Abstract**

The present application relates to the technical field of display. Disclosed are a display module and a preparation method therefor, and a display apparatus. The display module comprises a first trace, a second trace and a third trace. A first target portion of the first trace and a second target portion of the second trace are arranged in an offset manner, such that two boundary slope surfaces of the second target portion can be prevented from overlapping with two boundary slope surfaces of the first target portion, and thus the included angle between each boundary slope surface of the second target portion and a bearing surface of a base substrate is prevented from being too large. Furthermore, a third target portion of the third trace can climb on the boundary slope surfaces, which extend in a first direction, of the first target portion and the second target portion, such that climbing positions of the third target portion are increased, and thus a segment gap of the third target portion at each climbing position is relatively small. Therefore, the third trace can be prevented from virtual connection or breakage, such that the stability and reliability of the third trace are ensured, thereby improving the yield of the display module, and allowing a good display effect of the display module.

## Description

### TECHNICAL FIELD

The present disclosure relates to the field of display technologies, and in particular, to a display module and a method for manufacturing the same, and a display device.

### BACKGROUND

With the development of display industry, people have higher and higher requirements on the technology and quality of display products, and display modules with an extremely narrow border have become a development trend. As the border size of the display module decreases continuously, the requirement on the wiring in the fan-out region becomes higher.

### SUMMARY

Embodiments of the present disclosure provide a display module and a method for manufacturing the same, and a display device. The technical solutions are as follows.

In an aspect, a display module is provided. The display module includes:
a base substrate, including a display region and a fan-out region on a side of the display region;
a first trace layer disposed on a side of the base substrate and disposed in the fan-out region, wherein the first trace layer includes a first trace, and a first target portion of the first trace extends along a first direction;
a first insulating layer disposed on a side of the first trace layer away from the base substrate;
a second trace layer disposed on a side of the first insulating layer away from the base substrate and disposed in the fan-out region, wherein the second trace layer includes a second trace corresponding to the first trace, and a second target portion of the second trace extends along the first direction;
a second insulating layer disposed on a side of the second trace layer away from the base substrate; and
a third trace layer disposed on a side of the second insulating layer away from the base substrate and disposed in the fan-out region, wherein the third trace layer includes a third trace corresponding to the second trace, and a third target portion of the third trace extends along the first direction;
wherein an orthographic projection of the first target portion on the base substrate and an orthographic projection of the second target portion on the base substrate are partially overlapped to form a first overlapping region, and the first overlapping region extends along the first direction;
wherein one of the first trace and the second trace is a first target trace, and the other one of the first trace and the second trace is a second target trace; an orthographic projection of a target portion of the first target trace on the base substrate and an orthographic projection of the third target portion on the base substrate are partially overlapped to form a second overlapping region, the second overlapping region extending along the first direction; and an orthographic projection of a target portion of one of the second target trace and the third trace on the base substrate is within an orthographic projection of a target portion of the other one of the second target trace and the third trace on the base substrate.

In some embodiments, the first target trace is the first trace, and the second target trace is the second trace.

In some embodiments, the first trace includes a first boundary slope and a second boundary slope which extend along the first direction, and the second trace includes a third boundary slope and a fourth boundary slope which extend along the first direction; wherein
an orthographic projection of the third boundary slope on the base substrate, an orthographic projection of the first boundary slope on the base substrate, an orthographic projection of the fourth boundary slope on the base substrate, and an orthographic projection of the second boundary slope on the base substrate are sequentially arranged along a second direction, and the second direction intersects the first direction; and
the first boundary slope and the second boundary slope intersect a bearing surface of the base substrate, and an extending surface of the third boundary slope and an extending surface of the fourth boundary slope intersect the bearing surface of the base substrate.

In some embodiments, a taper angle between the extending surface of the third boundary slope and the bearing surface of the base substrate and a taper angle between the extending surface of the fourth boundary slope and the bearing surface of the base substrate range from 40 degrees to 50 degrees.

In some embodiments, the second target portion includes a first climbing portion located between the third boundary slope and the fourth boundary slope, wherein an orthographic projection of the first climbing portion on the base substrate at least partially overlaps the orthographic projection of the first boundary slope on the base substrate.

In some embodiments, the third target portion includes a second climbing portion, a third climbing portion and a fourth climbing portion; wherein
an orthographic projection of the second climbing portion on the base substrate at least partially overlaps the orthographic projection of the third boundary slope on the base substrate, an orthographic projection of the third climbing portion on the base substrate at least partially overlaps the orthographic projection of the first boundary slope on the base substrate, and an orthographic projection of the fourth climbing portion on the base substrate at least partially overlaps the orthographic projection of the fourth boundary slope on the base substrate.

In some embodiments, the orthographic projection of the first target portion on the base substrate has a first central axis extending along the first direction, the orthographic projection of the second target portion on the base substrate has a second central axis extending along the first direction, and the orthographic projection of the third target portion on the base substrate has a third central axis extending along the first direction; wherein
the first central axis and the second central axis are parallel and spaced apart from each other, and the second central axis and the third central axis overlap.

In some embodiments, a ratio of a minimum spacing between the first central axis and the second central axis to a length of the orthographic projection of the first target portion on the base substrate along a second direction ranges from 1/8 to 3/4.

In some embodiments, a minimum spacing between the first central axis and the second central axis ranges from 0.5 µm to 1.5 µm.

In some embodiments, the minimum spacing between the first central axis and the second central axis is 1 µm.

In some embodiments, a length of the orthographic projection of the first target portion on the base substrate along a second direction, a length of the orthographic projection of the second target portion on the base substrate along the second direction, and a length of the orthographic projection of the third target portion on the base substrate along the second direction all range from 2 µm to 4 µm.

In some embodiments, the first trace layer includes a plurality of first traces, the second trace layer includes a plurality of second traces in one-to-one correspondence with the plurality of first traces, and the third trace layer includes a plurality of third traces in one-to-one correspondence with the plurality of second traces.

In some embodiments, the first target portions of the plurality of first traces are equally spaced apart from each other along a second direction, the second target portions of the plurality of second traces are equally spaced apart from each other along the second direction, and the third target portions of the plurality of third traces are equally spaced apart from each other along the second direction.

In some embodiments, the plurality of first traces at least include a first first trace and a second first trace, the plurality of second traces at least include a first second trace and a second second trace; wherein the first second trace corresponds to the first first trace, and the second second trace corresponds to the second first trace; and
a distance between a first central axis of the first first trace and a second central axis of the first second trace is equal to a distance between a first central axis of the second first trace and a second central axis of the second second trace.

In some embodiments, the display module includes a touch panel and a display panel; wherein the touch panel at least includes a plurality of emission electrode traces, and the display panel at least includes a plurality of gate lines and a plurality of data lines; wherein
the first trace is the emission electrode trace, the second trace is the gate line, and the third trace is the data line.

In another aspect, a method for manufacturing a display module is provided. The method includes:
providing a base substrate, wherein the base substrate includes a display region and a fan-out region on a side of the display region;
forming a first trace film on a side of the base substrate and patterning the first trace film by using a first mask to form a first trace layer, wherein the first trace layer is disposed in the fan-out region and the first trace layer includes a first trace, and a first target portion of the first trace extends along a first direction;
forming a first insulating layer on a side of the first trace layer away from the base substrate;
forming a second trace film on a side of the first insulating layer away from the base substrate and patterning the second trace film by using a second mask to form a second trace layer, wherein the second trace layer is disposed in the fan-out region and the second trace layer includes a second trace corresponding to the first trace, and a second target portion of the second trace extends along the first direction;
forming a second insulating layer on a side of the second trace layer away from the base substrate; and
forming a third trace film on a side of the second insulating layer away from the base substrate and patterning the third trace film by using a third mask to form a third trace layer, wherein the third trace layer includes a third trace corresponding to the second trace, and a third target portion of the third trace extends along the first direction;
wherein an orthographic projection of the first target portion on the base substrate and an orthographic projection of the second target portion on the base substrate are partially overlapped to form a first overlapping region, and the first overlapping region extends along the first direction;
wherein one of the first trace and the second trace is a first target trace, and the other one of the first trace and the second trace is a second target trace, an orthographic projection of a target portion of the first target trace on the base substrate and an orthographic projection of the third target portion on the base substrate are partially overlapped to form a second overlapping region, the second overlapping region extending along the first direction; and an orthographic projection of a target portion of one of the second target trace and the third trace on the base substrate is within an orthographic projection of a target portion of the other one of the second target trace and the third trace on the base substrate.

In some embodiments, the first mask has a first opening for forming the first trace; the second mask has a second opening for forming the second trace; and the third mask has a third opening for the third trace; wherein
an orthographic projection of the first opening on the base substrate partially overlaps an orthographic projection of the second opening on the base substrate; and the orthographic projection of the first opening on the base substrate partially overlaps an orthographic projection of the third opening on the base substrate; and
the orthographic projection of one of the second opening and the third opening on the base substrate is within the orthographic projection of the other one of the second opening and the third opening on the base substrate.

In some embodiments, the display module includes a touch panel and a display panel; wherein the touch panel at least includes a plurality of emission electrode traces, and the display panel at least includes a plurality of gate lines and a plurality of data lines; wherein
the first trace is the emission electrode trace, the second trace is the gate line, and the third trace is the data line.

In still another aspect, a display device is provided. The display device includes a power supply assembly and the display module as described in the above aspect; wherein
the power supply assembly is configured to supply power to the display module.

### BRIEF DESCRIPTION OF DRAWINGS

To describe the technical solutions in the embodiments of the present disclosure more clearly, the accompanying drawings required for describing the embodiments are described below. The accompanying drawings in the following description show merely some embodiments of the present disclosure, and those of ordinary skill in the art may still derive other drawings from these accompanying drawings without creative effort.
FIG. 1 is a partial top view of a display module in the related art;
FIG. 2 is a sectional SEM image of the display module shown in FIG. 1 along an AA direction;
FIG. 3 is a sectional SEM image of the display module shown in FIG. 1 along a BB direction;
FIG. 4 is a schematic diagram after photoresist is subject to exposure and development when a second trace layer is formed in the related art;
FIG. 5 is a schematic diagram of etching when a second trace layer is formed in the related art;
FIG. 6 is a schematic diagram after photoresist is subject to exposure and development when a third trace layer is formed in the related art;
FIG. 7 is a schematic diagram of etching when a third trace layer is formed in the related art;
FIG. 8 is a schematic structural diagram of a display module according to some embodiments of the present disclosure;
FIG. 9 is a top view of a base substrate according to some embodiments of the present disclosure;
FIG. 10 is a partial top view of a display module according to some embodiments of the present disclosure;
FIG. 11 is a sectional view of the display module shown in FIG. 10 along a CC direction;
FIG. 12 is another sectional view of the display module shown in FIG. 10 along the CC direction;
FIG. 13 is still another sectional view of the display module shown in FIG. 10 along the CC direction;
FIG. 14 is a partial top view of another display module according to some embodiments of the present disclosure;
FIG. 15 is a sectional SEM image of the display module shown in FIG. 14 along a DD direction;
FIG. 16 is a sectional view of the display module shown in FIG. 14 along the DD direction;
FIG. 17 is a flowchart of a method for manufacturing a display module according to some embodiments of the present disclosure;
FIG. 18 is a schematic diagram after photoresist is subject to exposure and development when a third trace layer is formed according to some embodiments of the present disclosure;
FIG. 19 is a schematic diagram of etching when a third trace layer is formed according to some embodiments of the present disclosure; and
FIG. 20 is a schematic structural diagram of a display device according to some embodiments of the present disclosure.

### DETAILED DESCRIPTION

To make the objectives, technical solutions, and advantages of the present disclosure clearer, the embodiments of the present disclosure will be further described in detail below with reference to the accompanying drawings.

A display module includes a base substrate, and a first trace layer, a first insulating layer, a second trace layer, a second insulating layer and a third trace layer which are sequentially stacked on the base substrate. In the related art, in order to save the layout space of the fan-out region of the display module, the design scheme of completely overlapping the three trace layers is adopted, and the edges of the three trace layers are completely flush with each other. That is, a first trace of the first trace layer, a second trace of the second trace layer, and a third trace of the third trace layer are completely overlapped, and the edges thereof are completely flush with each other.

The first trace, the second trace and the third trace are all manufactured by first forming a layer of trace film, and then patterning the trace film to obtain a trace. Patterning the metal film includes: coating the side of the trace film away from the base substrate with photoresist, exposing the photoresist by using a mask, developing the exposed photoresist, etching the portion, not protected by the photoresist, of the trace film after development, and removing the remaining photoresist.

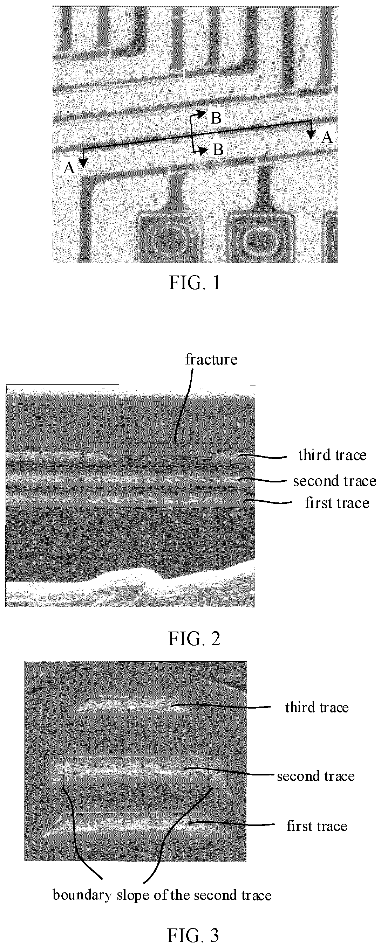

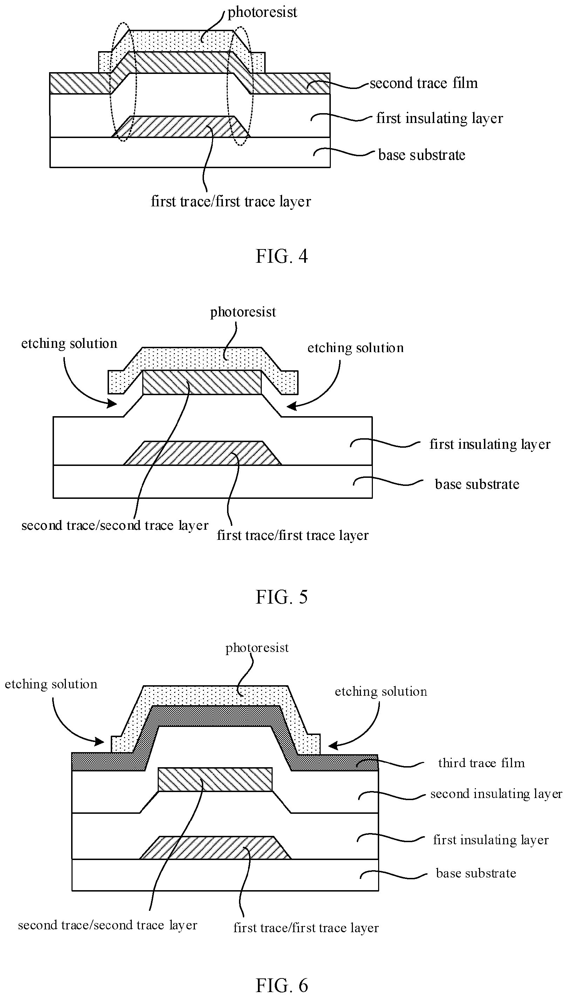

However, in the above solution, it is found that the third trace in the third trace layer is likely to be virtually connected or fracture (as shown in FIG. 1 to FIG. 3), and the defect rate is as high as 38.12%. The analysis shows that the main reasons for the high defect rate in this solution are as follows. Since the edge of the second trace in the second trace layer is flush with the edge of the first trace in the first trace layer, referring to FIG. 4, in the process of forming the second trace, the photoresist subjected to exposure and development climbs up the boundary slope of the first trace (at the positions shown in two dashed boxes in FIG. 4). Therefore, referring to FIG. 5, in the process of etching the second trace film later, the etching solution will etch the second trace film along the side surface of the photoresist, and the lateral etching rate will increase. As a result, the taper angle between the boundary slope of the finally formed second trace and the bearing surface of the base substrate is too large or even becomes 80° to 90°.

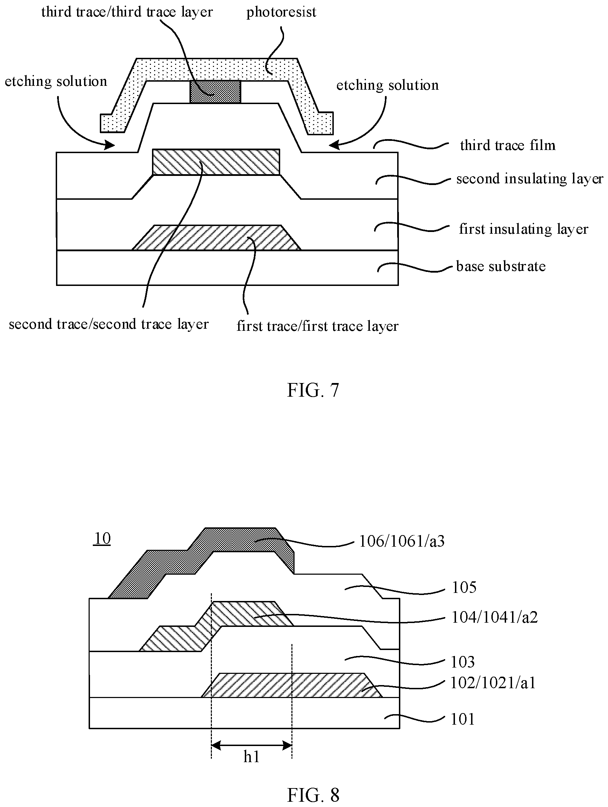

Further, since the edge of the third trace is completely flush with the edge of the second trace and the edge of the first trace, the segment difference of the third trace during slope climbing is large (the segment difference is the total thickness of the first trace and the second trace). In addition, since the taper angle of the second trace is large, referring to FIG. 6, in the subsequent manufacturing process of the third trace, the photoresist subjected to exposure and development will climb a steeper slope, and thus the coverage of the photoresist is poor. Referring to FIG. 7, in the process of etching the third metal film to form the third trace, the etching rate of the etching solution is greatly increased, resulting in excessive lateral etching of the third trace to cause high occurrence of line fractures or small gaps in large areas, which directly affects the product yield and product stability.

As shown in FIG. 2 and FIG. 3, the taper angle of the second trace is very large (approximate 90°), resulting in excessive lateral etching of the third trace. As a result, the third trace becomes thinner, and may even be disconnected in some locations.

FIG. 8 is a schematic structural diagram of a display module according to some embodiments of the present disclosure. Referring to FIG. 8, the display module 10 includes a base substrate 101, a first trace layer 102, a first insulating layer 103, a second trace layer 104, a second insulating layer 105, and a third trace layer 106. The first trace layer 102, the first insulating layer 103, the second trace layer 104, the second insulating layer 105 and the third trace layer 106 are sequentially stacked in a direction going away from the base substrate 101.

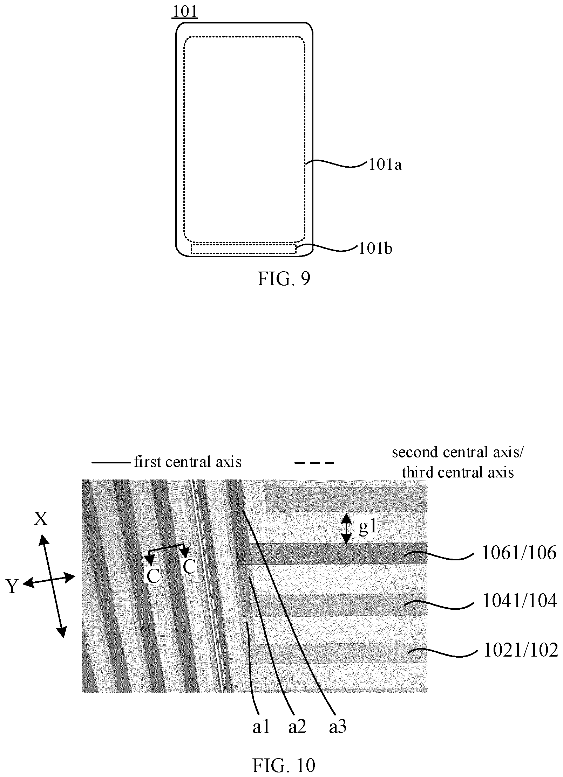

Referring to FIG. 9, the base substrate 101 includes a display region 101a and a fan-out region 101b on a side of the display region 101a. With reference to FIG. 8 to FIG. 10, the first trace layer 102, the second trace layer 104, and the third trace layer 106 are disposed in the fan-out region 101b. The first trace layer 102 includes a first trace 1021, and a first target portion a1 of the first trace 1021 extends along a first direction X. The second trace layer 104 includes a second trace 1041 corresponding to the first trace 1021, and a second target portion a2 of the second trace 1041 extends along the first direction X. The third trace layer 106 includes a third trace 1061 corresponding to the second trace 1041, and a third target portion a3 of the third trace 1061 extends along the first direction X. Two traces corresponding to each other refers to that the orthographic projections of the target portions of the two traces on the base substrate 101 at least partially overlap.

The first direction X intersects the pixel row direction and the pixel column direction. The first target portion a1, the second target portion a2, and the third target portion a3 are disposed in an inclined wiring zone of the fan-out region.

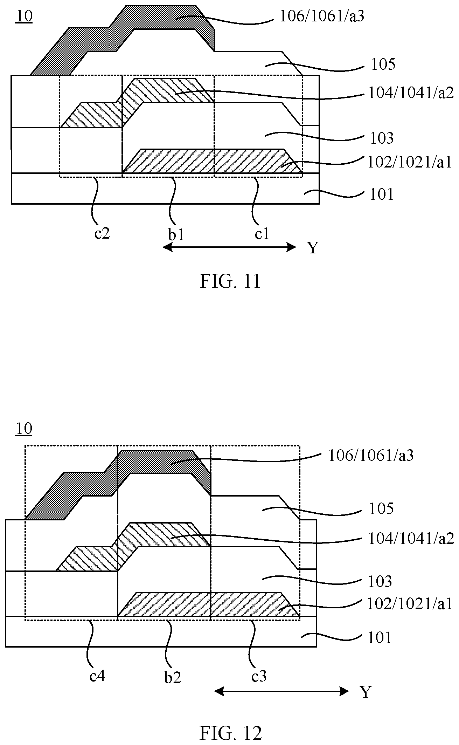

Referring to FIG. 11, the orthographic projection of the first target portion a1 on the base substrate 101 and the orthographic projection of the second target portion a2 on the base substrate 101 are partially overlapped to form a first overlapping region b1 in the second direction Y, and the first overlapping region b1 extends along the first direction X. That is, the orthographic projection of the first target portion a1 on the base substrate 101 includes a first non-overlapping region c1 that does not overlap the orthographic projection of the second target portion a2 on the base substrate 101, in addition to the first overlapping region b1 between the orthographic projection of the first target portion a1 on the base substrate 101 and the orthographic projection of the second target portion a2 on the base substrate 101. Correspondingly, the orthographic projection of the second target portion a2 on the base substrate 101 includes a second non-overlapping region c2 that does not overlap the orthographic projection of the first target portion a1 on the base substrate 101, in addition to the first overlapping region b1 between the orthographic projection of the second target portion a2 on the base substrate 101 and the orthographic projection of the first target portion a1 on the base substrate 101. Additionally, the first non-overlapping region c1, the first overlapping region b1, and the second non-overlapping region c2 are arranged along the second direction Y, and all extend along the first direction X. The second direction Y intersects the first direction X. For example, the second direction Y is perpendicular to the first direction X. That is, the first trace 1021 and the second trace 1041 are arranged with a shift therebetween in the second direction Y.

One of the first trace 1021 and the second trace 1041 is a first target trace, and the other trace is a second target trace. The orthographic projection of the target portion of the first target trace on the base substrate 101 and the orthographic projection of the third target portion a3 on the base substrate 101 are partially overlapped to form a second overlapping region b2, and the second overlapping region b2 extends along the first direction X. That is, the orthographic projection of the target portion of the first target trace on the base substrate 101 includes a third non-overlapping region c3 that does not overlap the orthographic projection of the third target portion a3 on the base substrate 101, in addition to the second overlapping region b2 between the orthographic projection of the target portion of the first target trace on the base substrate 101 and the orthographic projection of the third target portion a3 on the base substrate 101. Correspondingly, the orthographic projection of the third target portion a3 on the base substrate 101 includes a fourth non-overlapping region c4 that does not overlap the orthographic projection of the target portion of the first target trace on the base substrate 101, in addition to the second overlapping region b2 between the orthographic projection of the target portion of the first target trace on the base substrate 101 and the orthographic projection of the third target portion a3 on the base substrate 101. Additionally, the third non-overlapping region c3, the second overlapping region b2, and the fourth non-overlapping region c4 are arranged along the second direction Y, and all extend along the first direction X.

That is, the first target trace and the third trace 1061 are arranged with a shift therebetween in the second direction Y. For example, in the case that the first target trace is the first trace 1021, the first trace 1021 and the third trace 1061 are arranged with a shift therebetween in the second direction Y. The second overlapping region b2, the third non-overlapping region c3, and the fourth non-overlapping region c4 are shown in FIG. 12. In the case that the first target trace is the second trace 1041, the second trace 1041 and the third trace 1061 are arranged with a shift therebetween in the second direction Y.

In addition, the orthographic projection of the target portion of one of the second target trace and the third trace 1061 on the base substrate 101 is within the orthographic projection of the target portion of the other one of the second target trace and the third trace 1061 on the base substrate 101. For example, the orthographic projection of the target portion of the second target trace on the base substrate 101 is within the orthographic projection of the third target portion a3 on the base substrate 101. Alternatively, the orthographic projection of the third target portion a3 of the third trace 1061 on the base substrate 101 is within the orthographic projection of the target portion of the second target trace on the base substrate 101.

Therefore, the orthographic projection of the target portion of one trace on the base substrate 101 being within the orthographic projection of the target portion of the other trace on the base substrate 101 means that an area of the orthographic projection of the target portion of one trace on the base substrate 101 is less than or equal to an area of the orthographic projection of the target portion of the other trace on the base substrate 101. For example, the area of the orthographic projection of the target portion of the second target trace on the base substrate 101 is less than or equal to the area of the orthographic projection of the third target portion a3 of the third trace 1061 on the base substrate 101. Alternatively, the area of the orthographic projection of the third target portion a3 of the third trace 1061 on the base substrate 101 is less than or equal to the area of the orthographic projection of the target portion of the second target trace on the base substrate 101.

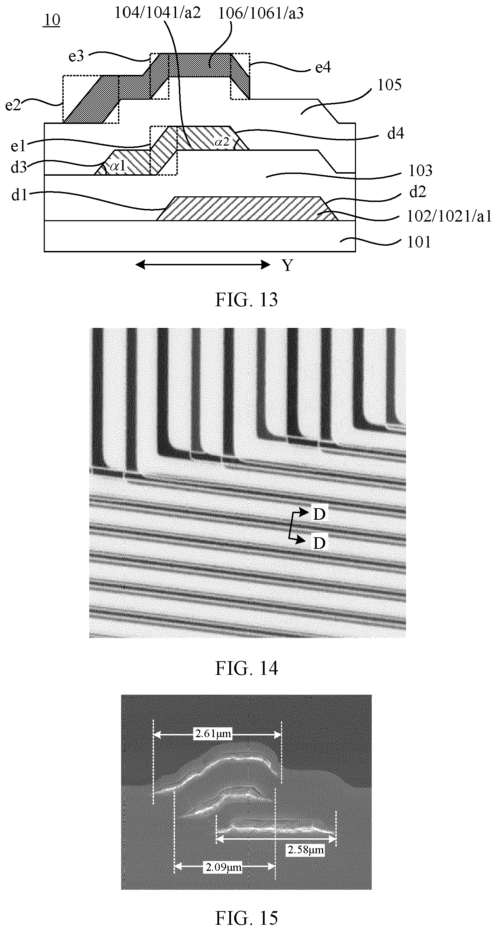

In the embodiments of the present disclosure, referring to FIG. 13, the first target portion a1 of the first trace 1021 includes a first boundary slope d1 and a second boundary slope d2 which extend in the first direction X. Since the second trace 1041 is disposed on the side of the first trace 1021 away from the base substrate 101, the second target portion a2 covers one boundary slope of the first target portion a1 and does not overlap the other boundary slope of the first target portion a1. For example, in FIG. 13, the second target portion a2 covers the first boundary slope d1 of the first target portion a1, and does not overlap the second boundary slope d2 of the first target portion a1. In this way, the second target portion a2 is disposed on and climbs up the first boundary slope d1 extending in the first direction X of the first target portion a1, but does not climb up the second boundary slope d2 of the first target portion a1. This design can prevent the two boundary slopes (a third boundary slope d3 and a fourth boundary slope d4) of the second target portion a2 from overlapping the two boundary slopes (the first boundary slope d1 and the second boundary slope d2) of the first target portion a1, thereby preventing the taper angle between each of the two boundary slopes of the second trace 1041 and the bearing surface of the base substrate 101 from being too large.

In addition, the third trace 1061 is disposed on the side of the second trace 1041 away from the base substrate 101. Thus, the third target portion a3 not only climbs up the boundary slope extending along the first direction X of the first target portion a1, but also climbs up the boundary slope extending along the first direction X of the second target portion a2. That is, the third target portion a3 is changed from only climbing up the boundary slope extending along the first direction X of the first target portion a1 to climbing up the boundary slopes extending along the first direction X of the first target portion a1 and the second target portion a2. In this way, on the basis of reducing the taper angle between each of the two boundary slopes of the second trace 1041 and the bearing surface of the base substrate 101, the number of climbing positions where the third target portion a3 climbs up is increased, thereby reducing the segment difference of each climbing position where the third target portion a3 climbs up. Furthermore, the third trace 1061 can be prevented from being virtually connected or fracturing, the stability and reliability of the third trace 1061 can be ensured, and the yield of the display module 10 can be improved. For example, tests show that the defect rate can be reduced to 0.5%.

In summary, the embodiments of the present disclosure provide a display module. The display module includes a first trace layer, a second trace layer, a third trace layer, a first insulating layer disposed between the first trace layer and the second trace layer, and a second insulating layer disposed between the second trace layer and the third trace layer. By arranging the first target portion of the first trace and the second target portion of the second trace with a shift therebetween, the two boundary slopes of the second target portion are prevented from overlapping the two boundary slopes of the first target portion, thereby preventing the taper angle between each of the boundary slopes of the second target portion and the bearing surface of the base substrate from being too large. Furthermore, the third target portion of the third trace can climb up the boundary slopes extending in the first direction of the first target portion and the second target portion, which increases the number of climbing positions where the third target portion climbs up, thereby reducing the segment difference of each climbing position where the third target portion climbs up. Therefore, the virtual connection or fracture of the third trace can be avoided, the stability and reliability of the third trace is ensured, and the yield and the display effect of the display module are improved.

In the embodiments of the present disclosure, the first trace 1021, the second trace 1041, and the third trace 1061 are all made of metal materials. Therefore, the first trace 1021 is also referred to as Metal_1 trace, the second trace 1041 is also referred to as Metal_2 trace, and the third trace 1061 is also referred to as Metal_3 trace.

In some embodiments, the first trace 1021, the second trace 1041 and the third trace 1061 are two-tandem stacked layers or three-tandem stacked layers. For example, the first trace 1021, the second trace 1041, and the third trace 1061 are one or more of a two-tandem stacked layer of Ti (titanium)/Cu (copper), a two-tandem stacked layer of MoNb (molybdenum niobium alloy)/Cu, a two-tandem stacked layer of MTD (molybdenum nickel titanium alloy)/Cu, and a three-tandem stacked layer of Mo (molybdenum)/Al (aluminum)/Mo.

In a first optional implementation, the first target trace is the first trace 1021, and the second target trace is the second trace 1041. That is, referring to FIG. 12, the orthographic projection of the first target portion a1 of the first trace 1021 on the base substrate 101 and the orthographic projection of the third target portion a3 on the base substrate 101 are partially overlapped to form the second overlapping region b2. The orthographic projection of the target portion of one of the second trace 1041 and the third trace 1061 on the base substrate 101 is within the orthographic projection of the target portion of the other one of the second trace 1041 and the third trace 1061 on the base substrate 101. For example, in FIG. 12, the orthographic projection of the second target portion a2 of the second trace 1041 on the base substrate 101 is within the orthographic projection of the third target portion a3 of the third trace 1061 on the base substrate 101.

In this implementation, the first target portion a1 of the first trace 1021 is arranged with a shift relative to the second target portion a2 of the second trace 1041, and is arranged with a shift relative to the third target portion a3 of the third trace 1061. The second target portion a2 of the second trace 1041 and the third target portion a3 of the third trace 1061 are arranged with no shift therebetween.

Referring to FIG. 12, the orthographic projection of the third boundary slope d3 on the base substrate 101, the orthographic projection of the first boundary slope d1 on the base substrate 101, the orthographic projection of the fourth boundary slope d4 on the base substrate 101, and the orthographic projection of the second boundary slope d2 on the base substrate 101 are sequentially arranged along the second direction Y.

The first boundary slope d1 and the second boundary slope d2 intersect the bearing surface of the base substrate 101. The extending surface of the third boundary slope d3 and the extending surface of the fourth boundary slope d4 intersect the bearing surface of the base substrate 101. It should be noted that the boundary slope or the extending surface of the boundary slope intersects the bearing surface of the base substrate 101 because the etching solution etches along the sidewall of the photoresist when the trace film is etched.

In some embodiments, the taper angle between the boundary slope or the extending surface of the boundary slope and the bearing surface of the base substrate 101 is an acute angle. For example, the area of the orthographic projection of the surface of the first target portion a1 away from the base substrate 101 on the base substrate 101 is smaller than the area of the orthographic projection of the surface of the first target portion a1 close to the base substrate 101 on the base substrate 101, and the orthographic projection of the surface of the first target portion a1 away from the base substrate 101 on the base substrate 101 is within the orthographic projection of the surface of the first target portion a1 close to the base substrate 101 on the base substrate 101. The area of the orthographic projection of the surface of the second target portion a2 away from the base substrate 101 on the base substrate 101 is smaller than the area of the orthographic projection of the surface of the second target portion a2 close to the base substrate 101 on the base substrate 101, and the orthographic projection of the surface of the second target portion a2 away from the base substrate 101 on the base substrate 101 is within the orthographic projection of the surface of the second target portion a2 close to the base substrate 101 on the base substrate 101.

In some embodiments, the taper angle α1 between the extending surface of the third boundary slope d3 and the bearing surface of the base substrate 101 and the taper angle α2 between the extending surface of the fourth boundary slope d4 and the bearing surface of the base substrate 101 both range from 40° to 50°.

In the embodiments of the present disclosure, the second target portion a2 of the second trace 1041 includes a first climbing portion e1 located between the third boundary slope d3 and the fourth boundary slope d4. The orthographic projection of the first climbing portion e1 on the base substrate 101 at least partially overlaps the orthographic projection of the first boundary slope d1 on the base substrate 101. For example, the orthographic projection of the first climbing portion e1 on the base substrate 101 covers the orthographic projection of the first boundary slope d1 on the base substrate 101. The first climbing portion e1 is arranged to climb up the first boundary slope d1.

Referring to FIG. 13, the third target portion a3 includes a second climbing portion e2, a third climbing portion e3 and a fourth climbing portion e4. The orthographic projection of the second climbing portion e2 on the base substrate 101 at least partially overlaps the orthographic projection of the third boundary slope d3 on the base substrate 101, the orthographic projection of the third climbing portion e3 on the base substrate 101 at least partially overlaps the orthographic projection of the first boundary slope d1 on the base substrate 101, and the orthographic projection of the fourth climbing portion e4 on the base substrate 101 at least partially overlaps the orthographic projection of the fourth boundary slope d4 on the base substrate 101. That is, the third target portion a3 includes three climbing positions. Compared with the prior art in which there are two climbing positions, the solution of the embodiments of the present disclosure increases the number of the climbing positions where the third target portion a3 climbs up. Moreover, since the number of the climbing positions is increased, the taper angle between the extending surface of the boundary slope at each climbing position and the bearing surface of the base substrate 101 can be reduced.

In the embodiments of the present disclosure, referring to FIG. 10, the orthographic projection of the first target portion a1 of the first trace 1021 on the base substrate 101 has a first central axis extending along the first direction X, the orthographic projection of the second target portion a2 on the base substrate 101 has a second central axis extending along the first direction X, and the orthographic projection of the third target portion a3 on the base substrate 101 has a third central axis extending along the first direction X. The first central axis and the second central axis are parallel and spaced apart from each other, and the second central axis and the third central axis overlap.

It should be noted that the first target portion a1 of the first trace 1021 and the second target portion a2 of the second trace 1041 being arranged with a shift therebetween refers to that the first central axis of the first target portion a1 and the second central axis of the second target portion a2 are arranged with a shift therebetween, that is, the first central axis and the second central axis do not overlap. The second target portion a2 of the second trace 1041 and the third target portion a3 of the third trace 1061 being arranged with no shift therebetween refers to that the second central axis of the second target portion a2 and the third central axis of the third target portion a3 are arranged with no shift therebetween, that is, the second central axis and the third central axis overlap.

In the embodiments of the present disclosure, if the first central axis and the second central axis are arranged with a too big shift therebetween, the narrow border of the display module 10 may be affected. If the first central axis and the second central axis are arranged with a too small shift therebetween, the first climbing portion e1 of the second target portion a2 may be too close to one of the boundary slopes of the second target portion a2, which may cause the taper angle between the boundary slope of the second target portion a2 and the bearing surface of the base substrate 101 to be too large, resulting in the virtual connection or fracture of the third target portion a3 above the second target portion a2.

In some embodiments, a ratio of the minimum spacing between the first central axis and the second central axis to the length of the orthographic projection of the first target portion a1 on the base substrate 101 along the second direction Y ranges from 1/8 to 3/4. Therefore, the first central axis of the first target portion a1 and the second central axis of the second target portion a2 are not arranged with a too small or too big shift therebetween. On the one hand, the narrow border of the display module can be facilitated, and on the other hand, the third target portion a3 can be prevented from being virtually connected or fracturing.

In some embodiments, referring to FIG. 8, the minimum spacing h1 between the first central axis and the second central axis ranges from 0.5 µm to 1.5 µm. That is, the first target portion a1 is arranged with a shift of 0.5 µm to 1.5 µm relative to the second target portion a2. For example, the minimum spacing between the first central axis and the second central axis is 1 µm.

In some embodiments, the length of the orthographic projection of the first target portion a1 on the base substrate 101 along the second direction Y (i.e., the projected width of the first target portion a1), the length of the orthographic projection of the second target portion a2 on the base substrate 101 along the second direction Y (i.e., the projected width of the second target portion a2), and the length of the orthographic projection of the third target portion a3 on the base substrate 101 along the second direction Y (i.e., the projected width of the third target portion a3) all range from 2 µm to 4 µm.

In addition, since the first target portion a1 is not arranged in a climbing manner, the actual width of the first target portion a1 is equal to the projected width of the first target portion a1. Since the second target portion a2 and the third target portion a3 are both arranged in a climbing manner, the actual width of the second target portion a2 is greater than the projected width of the second target portion a2, and the actual width of the third target portion a3 is greater than the projected width of the third target portion a3. In some embodiments, the actual width of the second target portion a2 ranges from 2.2 µm to 4.2 µm, and the ratio of the actual width to the projected width of the second target portion a2 ranges from 1.05 to 1.1. The actual width of the third target portion a3 ranges from 2.4 µm to 4.4 µm, and the ratio of the actual width to the projected width of the third target portion a3 ranges from 1.10 to 1.15.

In a second optional implementation, the first target trace is the second trace 1041, and the second target trace is the first trace 1021. That is, the orthographic projection of the second target portion a2 of the second trace 1041 on the base substrate 101 and the orthographic projection of the third target portion a3 on the base substrate 101 are partially overlapped to form the second overlapping region b2. The orthographic projection of the target portion of one of the first trace 1021 and the third trace 1061 on the base substrate 101 is within the orthographic projection of the target portion of the other one of the first trace 1021 and the third trace 1061 on the base substrate 101.

In this implementation, the second target portion a2 of the second trace 1041 is arranged with a shift relative to the first target portion a1 of the first trace 1021, and is arranged with a shift relative to the third target portion a3 of the third trace 1061. The first target portion a1 of the first trace 1021 and the third target portion a3 of the third trace 1061 are arranged with no shift therebetween.

It should be noted that, for other related content in this implementation, reference may be made to the descriptions of the foregoing first implementation, and details are not described herein again.

Comparing the first optional implementation with the second optional implementation, in the first implementation, the first target portion a1 of the first trace 1021 is arranged with a shift relative to the second target portion a2 of the second trace 1041 and the third target portion a3 of the third trace 1061, and in the second implementation, the second target portion a2 of the second trace 1041 is arranged with a shift relative to the first target portion a1 of the first trace 1021 and the third target portion a3 of the third trace 1061.

Since the first target portion a1 of the first trace 1021 is closer to the base substrate 101 than the second target portion a2 of the second trace 1041 is, when the display module is manufactured, the second target portion a2 needs to be formed after the first target portion a1 is formed. Therefore, compared with the solution of arranging the second target portion a2 with a shift (the second implementation), the solution of arranging the first target portion a1 with a shift (the first implementation) can more easily align the first central axis and the second central axis and determine the shift size between the first central axis and the second central axis, thereby increasing the manufacturing precision.

In the embodiments of the present disclosure, referring to FIG. 10, the first trace layer 102 includes a plurality of first traces 1021, the second trace layer 104 includes a plurality of second traces 1041 in one-to-one correspondence with the plurality of first traces 1021, and the third trace layer 106 includes a plurality of third traces 1061 in one-to-one correspondence with the plurality of second traces 1041.

For each first trace 1021, the first trace 1021 is arranged with a shift relative to the second trace 1041 corresponding to the first trace 1021, and is arranged with a shift relative to the third trace 1061 corresponding to the second trace 1041 in the way provided in the embodiments of the present disclosure.

In some embodiments, the first target portions a1 of the plurality of first traces 1021 are equally spaced apart from each other along the second direction Y, the second target portions a2 of the plurality of second traces 1041 are also equally spaced apart from each other along the second direction Y, and the third target portions a3 of the plurality of third traces 1061 are also equally spaced apart from each other along the second direction Y.

The first target portions a1 of the plurality of first traces 1021 being equally spaced apart from each other along the second direction Y refers to that the first central axes of the first target portions a1 of the plurality of first traces 1021 are equally spaced apart from each other along the second direction Y. The second target portions a2 of the plurality of second traces 1041 being equally spaced apart from each other along the second direction Y refers to that the second central axes of the second target portions a2 of the plurality of second traces 1041 are equally spaced apart from each other along the second direction Y. The third target portions a3 of the plurality of third traces 1061 being equally spaced apart from each other along the second direction Y refers to that the third central axes of the third target portions a3 of the plurality of third traces 1061 are equally spaced apart from each other along the second direction Y.

In some embodiments, the distance between the first central axes of two adjacent first target portions a1 along the second direction Y ranges from 2 µm to 4 µm. The distance between the second central axes of two adjacent second target portions a2 along the second direction Y ranges from 2 µm to 4 µm. The distance between the third central axes of two adjacent third target portions a3 along the second direction Y ranges from 2 µm to 4 µm.

In addition, referring to FIG. 10, the portion of the first trace 1021 other than the first target portion a1, the portion of the second trace 1041 other than the second target portion a2, and the portion of the third trace 1061 other than the third target portion a3 are not overlapped with each other and have a spacing therebetween. The distance g1 between the orthographic projections of any two adjacent traces on the base substrate 101 ranges from 4 µm to 6 µm.

Therefore, the shift size between the first central axis of the first target portion a1 of the first trace 1021 and the second central axis of the second target portion a2 of the second trace 1041 is a fixed size. That is, the distance between the first central axis of the first target portion a1 of each first trace 1021 and the second central axis of the second target portion a2 of the corresponding second trace 1041 is equal.

For example, the plurality of first traces 1021 at least include a first first trace 1021 and a second first trace 1021, and the plurality of second traces 1041 at least include a first second trace 1041 and a second second trace 1041. The first second trace 1041 corresponds to the first first trace 1021, and the second second trace 1041 corresponds to the second first trace 1021. The distance between the first central axis of the first first trace 1021 and the second central axis of the first second trace 1041 is equal to the distance between the first central axis of the second first trace 1021 and the second central axis of the second second trace 1041.

As shown in FIG. 14, by arranging the traces in each trace layer in the way provided in the embodiments of the present disclosure, the traces are prevented from virtual connection or fracture. In addition, as shown in FIG. 15, by arranging the traces in each trace layer in the way provided in the embodiments of the present disclosure, the taper angle of the second trace is prevented from being too large, and the climbing segment difference of the third trace is reduced.

In addition, referring to FIG. 15, the orthographic projection of the first target portion a1 of the first trace 1021 on the base substrate 101 has a length of about 2.58 µm in the second direction Y, the orthographic projection of the second target portion a2 of the second trace 1041 on the base substrate 101 has a length of about 2.09 µm in the second direction Y, and the orthographic projection of the third target portion a3 of the third trace 1061 on the base substrate 101 has a length of about 2.61 µm in the second direction Y. The orthographic projections of the target portions of the traces on the base substrate 101 have different lengths in the second direction Y.

In the embodiments of the present disclosure, the display module 10 includes a touch panel and a display panel. The touch panel at least includes a plurality of emission electrode traces, and the display panel at least includes a plurality of gate lines and a plurality of data lines. The first trace 1021 is the emission electrode trace (Tx trace), the second trace 1041 is the gate line, and the third trace 1061 is the data line (source line).

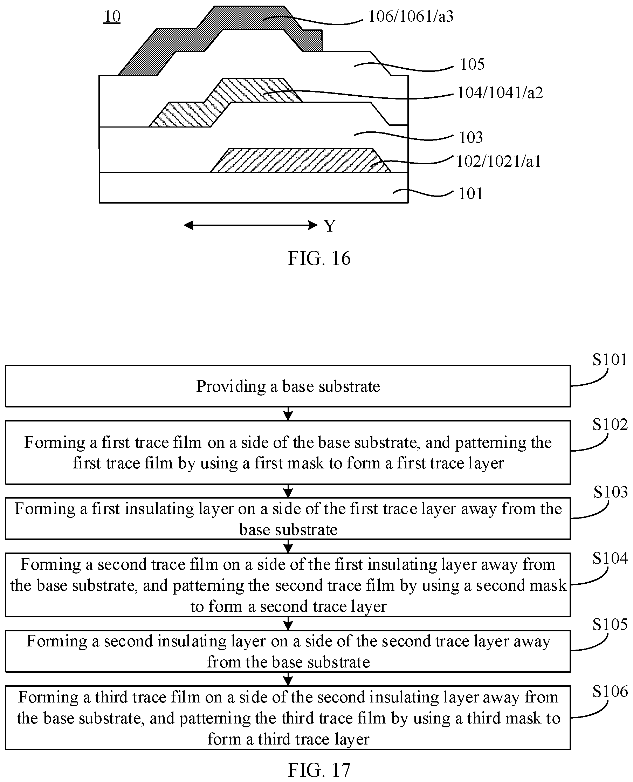

It should be noted that, referring to FIG. 15, the boundary of the second trace 1041 and the boundary of the third trace 1061 may not be completely flush with each other due to the influence of the manufacturing process and the like, which does not affect other related effects achieved by the embodiments of the present disclosure. For example, the display module shown in FIG. 15 or FIG. 16 can also prevent the third trace 1061 from virtual connection or fracture.

In addition, referring to FIG. 15, in an actual product, the two boundary slopes of the first trace 1021 may not be strictly planar, but may be arc-shaped surfaces which are recessed towards the base substrate 101. The surfaces of the second trace 1041 and the third trace 1061 away from the base substrate 101 may also be uneven surfaces. The morphology of the surface of each trace is related to the manufacturing process, and may be affected by the material, the etching process, the thickness of the film layer, and the thickness of the insulating layer between adjacent traces, for example.

In summary, the embodiments of the present disclosure provide a display module. The display module includes a first trace layer, a second trace layer, a third trace layer, a first insulating layer disposed between the first trace layer and the second trace layer, and a second insulating layer disposed between the second trace layer and the third trace layer. By arranging the first target portion of the first trace and the second target portion of the second trace with a shift therebetween, the two boundary slopes of the second target portion are prevented from overlapping the two boundary slopes of the first target portion, thereby preventing the taper angle between each of the boundary slopes of the second target portion and the bearing surface of the base substrate from being too large. Furthermore, the third target portion of the third trace can climb up the boundary slopes extending in the first direction of the first target portion and the second target portion, which increases the number of climbing positions where the third target portion climbs up, thereby reducing the segment difference of each climbing position where the third target portion climbs up. Therefore, the virtual connection or fracture of the third trace can be avoided, the stability and reliability of the third trace is ensured, and the yield and the display effect of the display module are improved.

FIG. 17 is a flowchart of a method for manufacturing a display module according to some embodiments of the present disclosure. The method is applicable to manufacturing the display module 10 provided in the foregoing embodiments. Referring to FIG. 17, the method includes the following steps.

In step S101, a base substrate is provided.

In the embodiments of the present disclosure, when the display module 10 is manufactured, a base substrate 101 is acquired first. The base substrate 101 is a glass substrate or a flexible substrate. The base substrate 101 includes a display region 101a and a fan-out region 101b on a side of the display region 101a.

In step S102, a first trace film is formed on a side of the base substrate, and the first trace film is patterned by using a first mask to form a first trace layer.

In the embodiments of the present disclosure, the first mask has a first opening for forming a first trace 1021 of the first trace layer 102. The process of patterning the first trace film by using the first mask includes: coating the side of the first trace film away from the base substrate 101 with a layer of photoresist; exposing the photoresist by using the first mask; developing the photoresist after exposure; etching the part of the developed first trace film which is not protected by the photoresist with an etching solution; and removing the remaining photoresist.

The first trace layer 102 is disposed in the fan-out region 101b, the first trace layer 102 includes the first trace 1021, and a first target portion a1 of the first trace 1021 extends along a first direction X.

In some embodiments, the display module includes a touch panel, and the touch panel includes an emission electrode trace. The first trace 1021 in the first trace layer 102 is the emission electrode trace in the touch panel.

In step S 103, a first insulating layer is formed on a side of the first trace layer away from the base substrate.

In the embodiments of the present disclosure, after the first trace layer 102 is formed, the first insulating layer 103 is formed on the side of the first trace layer 102 away from the base substrate 101. The first insulating layer 103 is configured to insulate the first trace layer 102 from a second trace layer 104 that is subsequently formed.

In step S104, a second trace film is formed on a side of the first insulating layer away from the base substrate, and the second trace film is patterned by using a second mask to form a second trace layer.

In the embodiments of the present disclosure, the process of patterning the second trace film by using the second mask includes: coating the side of the second trace film away from the base substrate 101 with a layer of photoresist; exposing the photoresist by using the second mask; developing the photoresist after exposure; etching the part of the developed second trace film which is not protected by the photoresist with an etching solution; and removing the remaining photoresist.

In some embodiments, the second trace layer 104 is disposed in the fan-out region 101b, the second trace layer 104 includes a second trace 1041, and a second target portion a2 of the second trace 1041 extends along the first direction X. The second mask has a second opening for forming the second trace 1041 of the second trace layer 104. An orthographic projection of the second opening on the base substrate 101 partially overlaps with an orthographic projection of the first opening on the base substrate 101. Therefore, an orthographic projection of the first target portion a1 of the first trace 1021 on the base substrate 101 and an orthographic projection of the second target portion a2 of the second trace 1041 on the base substrate 101 are partially overlapped to form a first overlapping region b1.

In some embodiments, the display module 10 includes a display panel, and the display panel includes a gate line. The second trace 1041 in the second trace layer 104 is the gate line in the display panel.

In step S105, a second insulating layer is formed on a side of the second trace layer away from the base substrate.

In the embodiments of the present disclosure, after the second trace layer 104 is formed, the second insulating layer 105 is formed on the side of the second trace layer 104 away from the base substrate 101. The second insulating layer 105 is configured to insulate the second trace layer 104 from a third trace layer 106 that is subsequently formed.

In step S106, a third trace film is formed on a side of the second insulating layer away from the base substrate, and the third trace film is patterned by using a third mask to form a third trace layer.

In the embodiments of the present disclosure, the process of patterning the third trace 1061 film by using the third mask includes: coating the side of the third trace 1061 film away from the base substrate 101 with a layer of photoresist; exposing the photoresist by using the third mask; developing the photoresist after exposure; etching the part of the developed third trace 1061 film which is not protected by the photoresist with an etching solution; and removing the remaining photoresist.

In some embodiments, the third trace layer 106 is disposed in the fan-out region 101b, the third trace layer 106 includes a third trace 1061, and a third target portion a3 of the third trace 1061 extends along the first direction X. The third mask has a third opening for forming the third trace 1061 of the third trace layer 106.

As a first optional implementation, in the process of manufacturing the first trace layer 102 and the second trace layer 104, in the case that the first mask is arranged with a shift and the second mask is arranged with no shift, the orthographic projection of the third opening of the third mask on the base substrate 101 partially overlaps the orthographic projection of the first opening of the first mask on the base substrate 101, and the orthographic projection of one of the second opening and the third opening on the base substrate 101 is within the orthographic projection of the other opening on the base substrate 101.

Therefore, in the manufactured display module, the orthographic projection of the first target portion a1 of the first trace 1021 on the base substrate 101 and the orthographic projection of the third target portion a3 of the third trace 1061 on the base substrate 101 are partially overlapped to form a second overlapping region b2. The second overlapping region b2 extends along the first direction X. In addition, the orthographic projection of the target portion of one of the second trace 1041 and the third trace 1061 on the base substrate 101 is within the orthographic projection of the target portion of the other one of the second trace 1041 and the third trace 1061 on the base substrate 101.

As a second optional implementation, in the process of manufacturing the first trace layer 102 and the second trace layer 104, in the case that the second mask is arranged with a shift and the first mask is arranged with no shift, the orthographic projection of the third opening of the third mask on the base substrate 101 partially overlaps the orthographic projection of the second opening of the second mask on the base substrate 101, and the orthographic projection of one of the first opening and the third opening on the base substrate 101 is within the orthographic projection of the other opening on the base substrate 101.

Therefore, in the manufactured display module, the orthographic projection of the second target portion a2 of the second trace 1041 on the base substrate 101 and the orthographic projection of the third target portion a3 of the third trace 1061 on the base substrate 101 are partially overlapped to form a second overlapping region b2. The second overlapping region b2 extends along the first direction X. In addition, the orthographic projection of the target portion of one of the first trace 1021 and the third trace 1061 on the base substrate 101 is within the orthographic projection of the target portion of the other one of the first trace 1021 and the third trace 1061 on the base substrate 101.

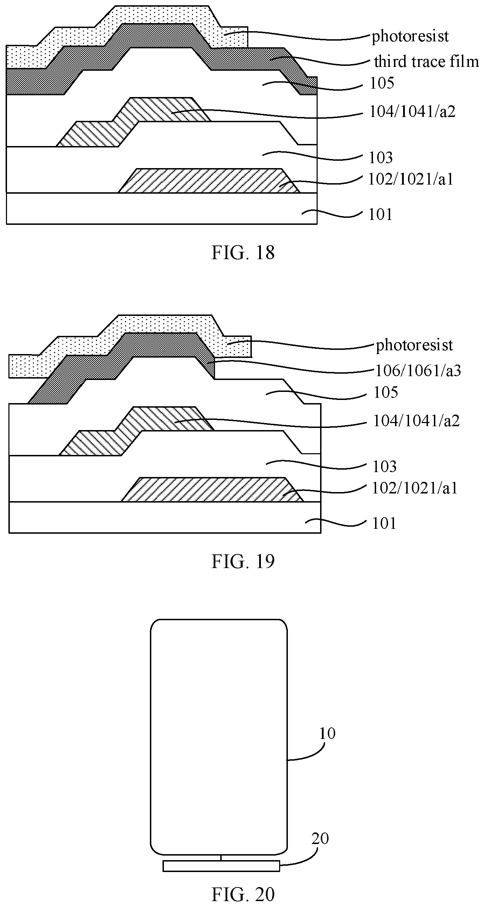

Referring to FIG. 18, the photoresist formed on the third trace film has a small climbing angle, so the photoresist has a better coverage effect. Therefore, as shown in FIG. 19, in the process of etching the third trace film, excessive lateral etching will not occur, thereby avoiding the problems such as line fracture or small gaps, and line fracture or virtual connection is effectively solved.

In some embodiments, the display module includes a display panel, and the display panel includes a data line. The third trace 1061 in the third trace layer 106 is the data line in the display panel.

In the embodiments of the present disclosure, from the process perspective, in order that the manufactured first trace 1021 and second trace 1041 are arranged with a shift therebetween, when the first trace 1021 or the second trace 1041 is manufactured, one of the first mask used to form the first trace 1021 and the second mask used to form the second trace 1041 is arranged with a shift of a certain distance relative to the other mask. In this method, a new mask is not required.

From the design perspective, the position of the first opening of the first mask or the position of the second opening of the second mask may be changed directly. In this method, a new mask is required.

In summary, the embodiments of the present disclosure provide a method for manufacturing a display module. The display module includes a first trace layer, a second trace layer, a third trace layer, a first insulating layer disposed between the first trace layer and the second trace layer, and a second insulating layer disposed between the second trace layer and the third trace layer. By arranging the first target portion of the first trace and the second target portion of the second trace with a shift therebetween, the two boundary slopes of the second target portion are prevented from overlapping the two boundary slopes of the first target portion, thereby preventing the taper angle between each of the boundary slopes of the second target portion and the bearing surface of the base substrate from being too large. Furthermore, the third target portion of the third trace can climb up the boundary slopes extending in the first direction of the first target portion and the second target portion, which increases the number of climbing positions where the third target portion climbs up, thereby reducing the segment difference of each climbing position where the third target portion climbs up. Therefore, the virtual connection or fracture of the third trace can be avoided, the stability and reliability of the third trace is ensured, and the yield and the display effect of the display module are improved.

FIG. 20 is a schematic structural diagram of a display device according to some embodiments of the present disclosure. Referring to FIG. 20, the display device includes a power supply assembly 20 and the display panel 10 as provided in the foregoing embodiments. The power supply assembly 20 is configured to supply power to the display panel 10.

In some embodiments, the display device may be any product or component having a display function, such as a liquid crystal display (LCD), an organic light-emitting diode (OLED) display device, an electronic paper, a low temperature poly-silicon (LTPS) display device, a low temperature poly-silicon oxide (LTPO) display device, an oxide display device, a mobile phone, a tablet computer, a television, a display, a notebook computer, a digital photo frame, or a navigator.

Since the display device substantially has the same technical effects as the display module described in the foregoing embodiments, the technical effects of the display device are not repeated herein for the sake of brevity.

Terms used in the embodiments of the present disclosure are only used to explain the embodiments of the present disclosure, and are not intended to limit the present disclosure. Unless otherwise defined, the technical terms or scientific terms used in the embodiments of the present disclosure should have the ordinary meanings understood by those skilled in the art to which the present disclosure belongs. The terms "first," "second," "third," and the like used in the specification and claims of the present disclosure do not denote any order, quantity, or importance, but are merely used to distinguish different components. Similarly, the similar words such as "alan" or "one" do not limit the quantity, but indicate the presence of at least one. The similar term "comprising" or "including" or the like means that the element or article before "comprising" or "including" encompasses the elements, objects or equivalents thereof listed after "comprising" or "including", without excluding other elements or objects. The words "connected to," "connected with," and the like are not limited to a physical connection or mechanical connection, but may include an electrical connection, directly or indirectly. "On," "under," "right," "left" and the like are only used to indicate the relative position relationship, and when the position of a described object changes, the relative position relationship may be also change accordingly. The value described by using the word "about" or "approximately" or "approximately the same" includes the stated value and the value is within an acceptable error range for a particular value as determined by one of ordinary skill in the art in consideration of the measurements discussed and the errors associated with the particular amount of measurement (i.e., limitations of the measurement system). For example, "about" may mean that the difference of the stated value is within one or more standard error ranges, or within the range of ± 30%, 20%, 10%, or 5%.

In the accompanying drawings, the thickness of the layers, films, panels, regions, or the like are exaggerated for clarity. Exemplary embodiments are described herein with reference to the cross-sectional view of a schematic diagram of an idealized embodiment. As such, the product may differ from the one shown in the accompanying drawings because of the manufacturing techniques and/or manufacturing tolerance. Thus, the embodiments described herein should not be construed as being limited to the specific shapes of regions as shown herein, but rather include deviations in terms of shape resulting from, for example, manufacturing. For example, a region illustrated or described as flat may typically have rough and/or nonlinear features. Further, the sharp corners illustrated may be rounded. Thus, the regions shown in the drawings are illustrative in nature, and their shapes are not intended to illustrate the precise shape of the regions, and are not intended to limit the scope of the claims.

The above descriptions are merely some optional embodiments of the present application, and are not intended to limit the present disclosure. Any variations, equivalent substitutions, improvements and the like made within the spirit and principles of the present disclosure shall be included within the protection scope of the present disclosure.

## Claims

1. A display module, comprising:
a base substrate (101), comprising a display region (101a) and a fan-out region (101b) on a side of the display region (101a);
a first trace layer (102) disposed on a side of the base substrate (101) and disposed in the fan-out region (101b), wherein the first trace layer (102) comprises a first trace (1021), and a first target portion (a1) of the first trace (1021) extends along a first direction (X);
a first insulating layer (103) disposed on a side of the first trace layer (102) away from the base substrate (101);
a second trace layer (104) disposed on a side of the first insulating layer (103) away from the base substrate (101) and disposed in the fan-out region (101b), wherein the second trace layer (104) comprises a second trace (1041) corresponding to the first trace (1021), and a second target portion (a2) of the second trace (1041) extends along the first direction (X);
a second insulating layer (105) disposed on a side of the second trace layer (104) away from the base substrate (101); and
a third trace layer (106) disposed on a side of the second insulating layer (105) away from the base substrate (101) and disposed in the fan-out region (101b), wherein the third trace layer (106) comprises a third trace (1061) corresponding to the second trace (1041), and a third target portion (a3) of the third trace (1061) extends along the first direction (X);
wherein an orthographic projection of the first target portion (a1) on the base substrate (101) and an orthographic projection of the second target portion (a2) on the base substrate (101) are partially overlapped to form a first overlapping region (b1), and the first overlapping region (b1) extends along the first direction (X);
wherein one of the first trace (1021) and the second trace (1041) is a first target trace, and the other one of the first trace (1021) and the second trace (1041) is a second target trace; an orthographic projection of a target portion of the first target trace on the base substrate (101) and an orthographic projection of the third target portion (a3) on the base substrate (101) are partially overlapped to form a second overlapping region (b2), the second overlapping region (b2) extending along the first direction (X); and an orthographic projection of a target portion of one of the second target trace and the third trace (1061) on the base substrate (101) is within an orthographic projection of a target portion of the other one of the second target trace and the third trace (1061) on the base substrate (101).

2. The display module according to claim 1, wherein the first target trace is the first trace (1021), and the second target trace is the second trace (1041).

3. The display module according to claim 2, wherein the first trace (1021) comprises a first boundary slope (d1) and a second boundary slope (d2) which extend along the first direction (X), and the second trace (1041) comprises a third boundary slope (d3) and a fourth boundary slope (d4) which extend along the first direction (X); wherein
an orthographic projection of the third boundary slope (d3) on the base substrate (101), an orthographic projection of the first boundary slope (d1) on the base substrate (101), an orthographic projection of the fourth boundary slope (d4) on the base substrate (101), and an orthographic projection of the second boundary slope (d2) on the base substrate (101) are sequentially arranged along a second direction (Y), and the second direction (Y) intersects the first direction (X); and
the first boundary slope (d1) and the second boundary slope (d2) intersect a bearing surface of the base substrate (101), and an extending surface of the third boundary slope (d3) and an extending surface of the fourth boundary slope (d4) intersect the bearing surface of the base substrate (101).

4. The display module according to claim 3, wherein a taper angle between the extending surface of the third boundary slope (d3) and the bearing surface of the base substrate (101) and a taper angle between the extending surface of the fourth boundary slope (d4) and the bearing surface of the base substrate (101) range from 40 degrees to 50 degrees.

5. The display module according to claim 3, wherein the second target portion (a2) comprises a first climbing portion (e1) located between the third boundary slope (d3) and the fourth boundary slope (d4), wherein an orthographic projection of the first climbing portion (e1) on the base substrate (101) at least partially overlaps the orthographic projection of the first boundary slope (d1) on the base substrate (101).

6. The display module according to claim 5, wherein the third target portion (a3) comprises a second climbing portion (e2), a third climbing portion (e3) and a fourth climbing portion (e4); wherein
an orthographic projection of the second climbing portion (e2) on the base substrate (101) at least partially overlaps the orthographic projection of the third boundary slope (d3) on the base substrate (101), an orthographic projection of the third climbing portion (e3) on the base substrate (101) at least partially overlaps the orthographic projection of the first boundary slope (d1) on the base substrate (101), and an orthographic projection of the fourth climbing portion (e4) on the base substrate (101) at least partially overlaps the orthographic projection of the fourth boundary slope (d4) on the base substrate (101).

7. The display module according to any one of claims 2 to 6, wherein the orthographic projection of the first target portion (a1) on the base substrate (101) has a first central axis extending along the first direction (X), the orthographic projection of the second target portion (a2) on the base substrate (101) has a second central axis extending along the first direction (X), and the orthographic projection of the third target portion (a3) on the base substrate (101) has a third central axis extending along the first direction (X); wherein
the first central axis and the second central axis are parallel and spaced apart from each other, and the second central axis and the third central axis overlap.

8. The display module according to claim 7, wherein a ratio of a minimum spacing between the first central axis and the second central axis to a length of the orthographic projection of the first target portion (a1) on the base substrate (101) along a second direction (Y) ranges from 1/8 to 3/4.

9. The display module according to claim 7 or 8, wherein a minimum spacing between the first central axis and the second central axis ranges from 0.5 µm to 1.5 µm.

10. The display module according to claim 9, wherein the minimum spacing between the first central axis and the second central axis is 1 µm.

11. The display module according to claim 9 or 10, wherein a length of the orthographic projection of the first target portion (a1) on the base substrate (101) along a second direction (Y), a length of the orthographic projection of the second target portion (a2) on the base substrate (101) along the second direction (Y), and a length of the orthographic projection of the third target portion (a3) on the base substrate (101) along the second direction (Y) all range from 2 µm to 4 µm.

12. The display module according to any one of claims 1 to 11, wherein the first trace layer (102) comprises a plurality of first traces (1021), the second trace layer (104) comprises a plurality of second traces (1041) in one-to-one correspondence with the plurality of first traces (1021), and the third trace layer (106) comprises a plurality of third traces (1061) in one-to-one correspondence with the plurality of second traces (1041).

13. The display module according to claim 12, wherein the first target portions (a1) of the plurality of first traces (1021) are equally spaced apart from each other along a second direction (Y), the second target portions (a2) of the plurality of second traces (1041) are equally spaced apart from each other along the second direction (Y), and the third target portions (a3) of the plurality of third traces (1061) are equally spaced apart from each other along the second direction (Y).

14. The display module according to claim 12 or 13, wherein the plurality of first traces (1021) at least comprise a first first trace (1021) and a second first trace (1021), the plurality of second traces (1041) at least comprise a first second trace (1041) and a second second trace (1041); wherein
the first second trace (1041) corresponds to the first first trace (1021), and the second second trace (1041) corresponds to the second first trace (1021); and
a distance between a first central axis of the first first trace (1021) and a second central axis of the first second trace (1041) is equal to a distance between a first central axis of the second first trace (1021) and a second central axis of the second second trace (1041).

15. The display module according to any one of claims 1 to 14, comprising: a touch panel and a display panel; wherein the touch panel at least comprises a plurality of emission electrode traces, and the display panel at least comprises a plurality of gate lines and a plurality of data lines; wherein
the first trace (1021) is the emission electrode trace, the second trace (1041) is the gate line, and the third trace (1061) is the data line.

16. A method for manufacturing a display module, comprising:
providing a base substrate (101), wherein the base substrate (101) comprises a display region (101a) and a fan-out region (101b) on a side of the display region (101a);
forming a first trace film on a side of the base substrate (101) and patterning the first trace film by using a first mask to form a first trace layer (102), wherein the first trace layer (102) is disposed in the fan-out region (101b) and the first trace layer (102) comprises a first trace (1021), and a first target portion (a1) of the first trace (1021) extends along a first direction (X);
forming a first insulating layer (103) on a side of the first trace layer (102) away from the base substrate (101);
forming a second trace film on a side of the first insulating layer (103) away from the base substrate (101) and patterning the second trace film by using a second mask to form a second trace layer (104), wherein the second trace layer (104) is disposed in the fan-out region (101b) and the second trace layer (104) comprises a second trace (1041) corresponding to the first trace (1021), and a second target portion (a2) of the second trace (1041) extends along the first direction (X);
forming a second insulating layer (105) on a side of the second trace layer (104) away from the base substrate (101); and
forming a third trace (1061) film on a side of the second insulating layer (105) away from the base substrate (101) and patterning the third trace (1061) film by using a third mask to form a third trace layer (106), wherein the third trace layer (106) comprises a third trace (1061) corresponding to the second trace (1041), and a third target portion (a3) of the third trace (1061) extends along the first direction (X);
wherein an orthographic projection of the first target portion (a1) on the base substrate (101) and an orthographic projection of the second target portion (a2) on the base substrate (101) are partially overlapped to form a first overlapping region (b 1), and the first overlapping region (b 1) extends along the first direction (X);
wherein one of the first trace (1021) and the second trace (1041) is a first target trace, and the other one of the first trace (1021) and the second trace (1041) is a second target trace, an orthographic projection of a target portion of the first target trace on the base substrate (101) and an orthographic projection of the third target portion (a3) on the base substrate (101) are partially overlapped to form a second overlapping region (b2), the second overlapping region (b2) extending along the first direction (X); and an orthographic projection of a target portion of one of the second target trace and the third trace (1061) on the base substrate (101) is within an orthographic proj ection of a target portion of the other one of the second target trace and the third trace (1061) on the base substrate (101).

17. The method according to claim 16, wherein the first mask has a first opening for forming the first trace (1021); the second mask has a second opening for forming the second trace (1041); and the third mask has a third opening for the third trace (1061); wherein
an orthographic projection of the first opening on the base substrate (101) partially overlaps an orthographic projection of the second opening on the base substrate (101); and the orthographic projection of the first opening on the base substrate (101) partially overlaps an orthographic projection of the third opening on the base substrate (101); and
the orthographic projection of one of the second opening and the third opening on the base substrate (101) is within the orthographic projection of the other one of the second opening and the third opening on the base substrate (101).

18. The method according to claim 16 or 17, wherein the display module comprises a touch panel and a display panel; wherein the touch panel at least comprises a plurality of emission electrode traces, and the display panel at least comprises a plurality of gate lines and a plurality of data lines; wherein
the first trace (1021) is the emission electrode trace, the second trace (1041) is the gate line, and the third trace (1061) is the data line.

19. A display device, comprising: a power supply assembly (20) and the display module (10) according to any one of claims 1 to 15; wherein
the power supply assembly (20) is configured to supply power to the display module (10).
